# EUROPEAN PATENT APPLICATION

(11) **EP 0 725 452 A1**
(43) Date of publication of application: **07.08.1996**
(21) Application number: 96300732.3
(22) Date of filing: 31.01.1996
(51) Int. Cl.: H01L 41/113, H02N 2/18

(54) **Piezoelectric power generator portable power supply unit equipped with the same, and portable electronic device equipped with the same**

(30) Priority: 01.02.1995 JP 15117/95; 24.11.1995 JP 306188/95; 12.01.1996 JP 4362/96
(71) Applicant: SEIKO EPSON CORPORATION, Shinjuku-ku Tokyo 163 (JP)
(72) Inventor: Takahashi, Osamu, c/o Seiko Epson Corporation, Suwa-shi, Nagano-ken 392 (JP); Hashimoto, Yasuharu, c/o Seiko Epson Corporation, Suwa-shi, Nagano-ken 392 (JP); Nagasaka, Eiichi, c/o Seiko Epson Corporation, Suwa-shi, Nagano-ken 392 (JP); Miyazaki, Hajime, c/o Seiko Epson Corporation, Suwa-shi, Nagano-ken 392 (JP); Funaska, Tsukasa, c/o Seiko Epson Corporation, Suwa-shi, Nagano-ken 392 (JP)
(74) Representative: Sturt, Clifford Mark

(57) **Abstract**

In a power generator including a piezoelectric transducer which generates electric power upon application of a strain, efficiency of converting strain energy into electric energy is improved to achieve a small-sized piezoelectric power generator having a charging capability adaptable for practical use and to provide a portable electronic device equipped with the piezoelectric power generator. The power generator includes a vibrating arm (21) having a sandwich structure wherein a support layer (26) is held between piezoelectric portions (22a) and (22b) on both sides, the vibrating arm being wider in the side of a support end (24) than in the side of a free end (23). Since the piezoelectric portions (22a) and (22b) are extended to a root portion of the vibrating arm (21), strain energy can efficiently be converted into electric energy. Since the piezoelectric portions (22a) and (22b) each have a laminated structure, a piezoelectric power generator having the electromotive voltage and the capacitance optimum for charging can be realized. In one embodiment two vibrating arms are provided, having their ends coupled together, so that they are in the form of a tuning fork.

## Description

The present invention relates to a piezoelectric power generator for generating electric power by utilizing mechanical vibrations, and more particularly, but not exclusively, to a piezoelectric power generator in which kinetic energy of a weight or the like is converted into electric energy through a vibrating arm (beam) and which can be mounted in small-sized portable devices such as watches, and a portable electronic device equipped with the piezoelectric power generator.

As a small-sized power supply unit for portable watches, Japanese Patent Publication No. 51-17393 discloses a small-sized portable power supply unit wherein electric power is generated by applying a strain to a piezoelectric transducer with motion of a rotating weight. In the disclosed small-sized portable power supply unit, a piezoelectric transducer is fixedly attached to a spring-like lever so that a strain is repeatedly applied to the piezoelectric transducer with vibrations of the lever and electric power generated by the piezoelectric transducer is utilized as source power.

In such a power generator for generating electric power with vibrations of the piezoelectric transducer, energy (hereinafter defined as input energy) applied to the spring-like lever and the piezoelectric transducer is mainly divided into three kinds, i.e., strain energy of the spring-like lever, strain energy of the piezoelectric transducer, and electric energy generated by the piezoelectric transducer and stored in an electric condensing portion. Of these three kinds of energy, the electric energy that is most important for the power generator fluctuates depending on the electro-mechanical coupling coefficient of the piezoelectric transducer, the output voltage (hereinafter referred to as electromotive voltage) and capacitance of the piezoelectric transducer when it is not charged, the voltage of the electric condensing portion (hereinafter referred to as condenser voltage), etc., but is only several % of the strain energy of the piezoelectric transducer. However, since the lever repeats vibration and a strain is applied to the piezoelectric transducer many times, the strain energy of both the spring-like lever and the piezoelectric transducer can be converted into electric energy in a gradually increasing manner. Therefore, it is finally possible to produce electric energy in a larger amount than converted per one cycle of vibration. Nevertheless, the conversion efficiency represented by the total amount of output electric energy as compared with the input energy is low and a need exists in improving the conversion efficiency from the practical point of view.

As mentioned above, the power generator using a piezoelectric transducer, described in Japanese Patent Publication No. 51-17393, can generate electric power, but its outer configuration is too large to be used in portable devices. With the view of realizing practical use of the power generator using a piezoelectric transducer, the inventors have made studies on the following items and have accomplished a small-sized power generator with higher conversion efficiency.

First, in a cantilevered beam comprising a spring-like lever and a piezoelectric transducer attached to the lever, strain energy of both the spring-like lever and the piezoelectric transducer is liable to leak through a fixed portion. This increases energy loss (hereinafter referred to as vibration leakage) and makes it difficult to improve the conversion efficiency. The vibration leakage can be reduced by increasing the rigidity of the fixed portion. But, increasing the rigidity of the fixed portion would result in larger size of the fixed portion and hence has limitations when portable devices are intended.

Secondly, a piezoelectric transducer converts strain energy applied to itself in the form of only compression and tension into electric energy with efficiency corresponding to a degree of the compression and tension. As this time, only a very small part of strain energy of the spring-like lever is imparted as strain energy of the piezoelectric transducer and, therefore, the conversion efficiency is very low. In particular, strain energy in a root portion of the spring-like lever which undergoes a maximum strain is not imparted to the piezoelectric transducer, and this contributes to the fact that the conversion efficiency is very low. Further, because the spring-like lever and the piezoelectric transducer are joined to each other through an adhesive layer, the adhesive layer behaves as a buffer member to reduce the strain to be applied to the piezoelectric transducer and also produces energy loss therein. Accordingly, most of the input energy is lost as the vibration leakage.

Thirdly, because a piezoelectric transducer has a small capacitance (electrostatic capacity), the power generator using a piezoelectric transducer can easily produce a high voltage, but a generated current is very small. This results in poor efficiency when the power generator is employed for charging of a power supply with a level of several V which is used in portable electronic devices.

Fourthly, while it is convenient from the structural point of view of the vibrating arm to generate electric power by utilizing a transverse effect wherein the direction of propagation of elastic waves is perpendicular to the direction of generated voltage, the conversion efficiency can further be increased if electric power is generated by utilizing a longitudinal effect wherein the direction of propagation of elastic waves is the same as the direction of the generated voltage and the electro-mechanical coupling coefficient has a larger value. However, the structure of the conventional vibrating arm has difficulties in utilizing the longitudinal effect.

Thus, an object of the present invention is to improve the conversion efficiency of the power generator using a piezoelectric transducer and to provide a piezoelectric power generator which has a small size and can be practised as a power supply unit for portable devices.

Another object of the present invention is to provide a piezoelectric power generator which can efficiently utilize strain energy and produce a large current value while reducing the vibration leakage.

Still another object of the present invention is to provide a piezoelectric power generator which can generate electric power by utilizing the longitudinal effect.

A further object of the present invention is to provide a piezoelectric power generator in which vibrations are less attenuated and mechanical energy can efficiently be converted into electric energy.

Yet another object of the present invention is to provide a piezoelectric power generator suitable for use in portable electronic devices, and a portable electronic device equipped with the piezoelectric power generator.

According to a first aspect of the present invention there is provided a piezoelectric power generator comprising: at least one vibrating arm having a free end being able to freely vibrate and a support end for supporting said free end, at least two piezoelectric portions laminated with a support layer therebetween, and electrodes covering at least part of surfaces of said piezoelectric portions, said vibrating arm or arms including a power generating section capable of outputting an alternating current through said electrodes and being formed at least on the side of said support end, the percentage of cross-sectional area of said support layer in said power generating section being not larger than substantially 60%.

The power generating section in one embodiment is the vibrating portion of the vibrating arm. In another embodiment the power generating section is the vibrating portion of the vibrating arm wherein both piezoelectric portions and electrodes exist.

Preferably the relative thickness of the support layer to the piezoelectric portions is substantially 20%.

Conveniently, the vibrating arm is formed such that stresses occurring therein are substantially equal throughout the arm so that any part of piezoelectric portions has a substantially uniform power generating capability. Thus, variations in distribution of the electric charges and electromotive voltages may be reduced and efficient power generation may be achieved.

Advantageously a member to which an impact is applied for vibrating the vibrating arm forms part of the support layer. Thus, vibrations caused by the impact can be conveyed to the piezoelectric portions by the support layer, but without necessitating any direct impact on the piezoelectric portions. This is advantageous because piezoelectric transducers widely employed nowadays are made of a ceramic-base material, which may be relatively easily damaged.

Preferably, only the parts of the piezoelectric portions which will contribute to the power generation are covered by the electrodes so that the power generator can keep a high voltage without reducing the electromotive voltage.

The piezoelectric portions may be formed by depositing laminated layers on the support layer by vapour deposition or sputtering. Such methods are advantageous when compared with conventional methods using an adhesive because the adhesive generally serves as a buffer member which reduces the strain applied to the piezoelectric portions, which results in energy loss. Additionally, differences in adhesion strength and shifts in position of the piezoelectric portions are less likely using vapour deposition or sputtering methods.

According to a second aspect of the present invention there is provided a piezoelectric power generator comprising: at least one vibrating arm having a free end being able to freely vibrate and a support end for supporting said free end, at least two piezoelectric portions laminated together, and electrodes covering at least part of the surfaces of said piezoelectric portions, said vibrating arm or arms including a power generating section capable of outputting an alternating current through said electrode and being formed at least on the side of said support end.

According to a third aspect of the present invention there is provided a piezoelectric power generator comprising: two vibrating arms each having a free end being able to freely vibrate and a support end for supporting said free end, at least two piezoelectric portions disposed on each of said two vibrating arms, and electrodes covering at least parts of surfaces of said piezoelectric portions, each of said two vibrating arms including a power generating section capable of outputting an alternating current through said electrodes, said two vibrating arms being combined into the form of a tuning fork with their support ends coupled to each other.

In one configuration the two vibrating arms are connected at their support ends, with the vibrating arms being configured such that the respective piezoelectric portions of the vibrating arms are in substantially parallel planes.

The present invention also relates to a portable power supply unit comprising a piezoelectric power generator as defined above, and including a rectifying device and an electric condensing device. A processing unit may also be provided for carrying out necessary processes with the electric power supplied from the electric condensing device.

The present invention also relates to a portable electronic device having a piezoelectric power generator as defined above and/or a portable power supply unit as defined above. Such a portable electronic device could be a wrist watch.

According to a fourth aspect of the present invention, there is provided a piezoelectric power generator comprising at least one vibrating arm having a piezoelectric portion, an electrode, and a power generating section for outputting a current through said electrode, characterised in that the piezoelectric portion and/or the vibrating arm or arms are substantially triangular or trapezoidal in shape.

According to a fifth aspect of the present invention, there is provided a piezoelectric power generator comprising at least one vibrating arm having a piezoelectric portion, an electrode, and a power generating section for outputting current through said electrode, characterised in that the electrode is provided only at the end of the vibrating arm which is able to freely vibrate.

In the power generator according to one aspect of the present invention, using a piezoelectric substance, the piezoelectric substance is extended to a root portion of the vibrating arm and the percentage of cross-sectional area of a support layer, such as a spring-like lever, is restricted within a predetermined range for enabling strain energy to be effectively utilized for power generation. More specifically, the piezoelectric power generator may comprise at least two piezoelectric portions laminated with a support layer therebetween, electrodes covering at least parts of surfaces of the piezoelectric portions, and a power generating section capable of outputting an alternating current through the electrodes, the power generating section being formed at least on the side of a support end of a vibrating arm which has a free end being able to freely vibrate and the support end for supporting the free end. Further, the percentage of cross-sectional area of the support layer in the power generating section may be set to be not larger than about 60%. It is a matter of course that the piezoelectric portions may be laminated directly or with the support layer therebetween.

In the piezoelectric power generator of the above arrangement, the piezoelectric portions are provided on the side of the support end of the vibrating arm, i.e. in the root portion thereof, which undergoes a maximum strain and through which strain energy is liable to leak, so that the strain energy in the root portion can efficiently be transmitted to the piezoelectric portions for conversion into electric energy. If most of strain energy is concentrated into the support layer such as a spring-like lever, it would be difficult to recover the concentrated strain energy for conversion into electric energy. For this reason, the percentage of cross-sectional area of the support layer in the power generating section is kept within the range capable of providing high conversion efficiency based on experiment results described later.

In the vibrating arm of a sandwich structure comprising the piezoelectric portions on both sides of a thin support layer, the amount of strain energy transmitted to the support layer can be reduced. Also, since the support layer can serve as a hit portion, e.g., an impacted surface, to which input energy is applied, a direct impact upon the piezoelectric portions can be avoided and a power generator having high reliability can be realized. Further, a trouble possibly caused by impacts can be prevented by attaching a weight to a tip of the free end of the vibrating arm and applying a hit against the weight so as to freely vibrate.

By employing the sandwich structure including the support layer, the support layer can be used as an electric path for the piezoelectric portions. It is therefore possible to connect the piezoelectric portions in series or in parallel through the support layer, or employ the support layer as an electrode for connection to a rectifying device.

It is preferable that the vibrating arm be formed to have a substantially triangular or trapezoidal shape such that size of the piezoelectric portions in the widthwise direction perpendicular to the direction of vibration of the vibrating arm is wider in the side of the support end than in the side of the free end. With such a configuration, stresses incurred due to vibrations can be dispersed almost uniformly over the piezoelectric portions, resulting in higher conversion efficiency.

When the support end of the vibrating arm is fixed a stationary member, strain energy produced in the root portion of the vibrating arm can easily be converted into electric energy by providing the piezoelectric portions over a portion at which the vibrating arm is fixed to the stationary member and a portion extending from the fixed portion toward the free end. The electrodes can be provided anywhere on the vibrating arm if provided over the piezoelectric portions, not only in the extended portion of the vibrating arm but in the whole portion. In this case, it is preferable that the electrodes be provided in the extended portion, but not in the fixed portion as far as possible. By providing the electrodes in the extended portion over which the piezoelectric portions are disposed, the root portion of the vibrating member can be utilized as the power generating section and the strain energy applied to the root portion can be utilized more efficiently. Since the fixed portion of the vibrating arm will not contribute to the power generation, the electrodes are not provided in the fixed portion for preventing charges from dispersing uselessly and suppressing a drop of the electromotive voltage. On the other hand, with the piezoelectric portions extended to the fixed portion, stresses applied to edges of the piezoelectric portions can be alleviated. Specifically, by extending the piezoelectric portions to the fixed portion, the piezoelectric portions cover the entire vibrating arm from the free end to the fixed portion via the support end. As a result, stresses are avoided from locally concentrating on the root side of the piezoelectric portions, and the piezoelectric portions may be prevented from being broken.

A power generator is required to generate a higher voltage than that of a charging system. Also, in a power generator using a vibrating arm, because the electromotive voltage is reduced as vibrations attenuate, a sufficient level of the electromotive voltage is required initially. Accordingly, it is preferable for producing a higher electromotive voltage that the area of the electrode be not increased unnecessarily as mentioned above, and that first and second piezoelectric portions making up the piezoelectric portions be polarized in opposite directions and are connected in series. By polarizing the first and second piezoelectric portions in opposite directions, these two piezoelectric portions are connected in series through the support layer so that a higher electromotive voltage can be obtained from both sides of the vibrating arm. Thus, since a sufficient level of the electromotive voltage is produced even with a small initial displacement of the vibrating arm, it is possible to reduce energy loss due to attenuation of vibrations and to increase the conversion efficiency.

Furthermore, in a power generator, it is important to increase a value of the generated current. Particularly, a power generator using a piezoelectric transducer has more difficulty in increasing a current than a voltage. From this reason, a piezoelectric power generator is preferably arranged so as to increase a current value. In the piezoelectric power generator of the present invention, each of the piezoelectric portions comprises a plurality of piezoelectric layers laminated in the direction of polarization, and the piezoelectric layers are connected in parallel with electrodes disposed between the piezoelectric layers. This arrangement increases the electrode area in parts of the piezoelectric portions which will contribute to the power generation, and a sufficient cross-section of each piezoelectric portion can easily be achieved by laminating a plurality of thin piezoelectric layers. Therefore, a capacitance of the power generating section can be increased to a large extent and hence a large current value can be realized.

When the piezoelectric portions are polarized in a direction substantially perpendicular to the direction interconnecting the free end and the support end of the vibrating arm, electric power can be generated by utilizing the transverse effect. When the piezoelectric portions are polarized substantially in the direction interconnecting the free end and the support end of the vibrating arm, electric power can be generated by utilizing the longitudinal effect. In particular, by generating electric power by utilization of the longitudinal effect, the power generation can be performed with a high coupling coefficient and hence the conversion efficiency can be improved to a large extent.

Moreover, by combining two vibrating arms, each of which has the power generating section, into the form of a tuning fork, there can be obtained a structure which is superior in continuing vibrations and is effective in reducing attenuation of vibrations and improving the conversion efficiency. To suppress attenuation of vibrations and improve the conversion efficiency, it is preferable to employ a vibration applying mechanism for imparting displacements in opposite directions to the two vibrating arms combined into the form of a tuning fork. By using such a vibration applying mechanism, a vibration mode as a tuning fork can be developed in the vibrating arms.

The vibration applying mechanism may comprise a hitting portion for hitting against the free end of one of the two vibrating arms in a direction toward the other vibrating arm, and a wall portion against which the free end of the other vibrating arm strikes when a hit is applied to one vibrating arm. The two vibrating arms combined into the form of a tuning fork are vibrated by being sandwiched between the hitting portion and the wall portion. The hitting portion can be moved by a weight which is movable like a pendulum.

As an alternative, the two vibrating arms combined into the form of a tuning fork may be supported such that their free ends are movable like a pendulum, and the vibration applying mechanism may include a wall portion against which the free end of one of the vibrating arm strikes. With this arrangement, when the vibrating arms are swung externally, displacements in opposite directions are applied to the two vibrating arms which can be thereby vibrated in the tuning-fork vibration mode with less attenuation. Further, by employing another vibration applying mechanism arranged so as to hit against substantially the centre of a member coupling, on the side of the support ends, the two vibrating arms combined into the form of a tuning fork from the side of the vibrating arms, displacements in opposite directions can also be applied to the two vibrating arms. Additionally, by employing still another vibration applying mechanism which includes a vibration applying member having a first portion to widen the distance between the free ends of the two vibrating arms combined into the form of a tuning fork, and a second portion sufficiently thin to pass between the free ends of the two vibrating arms, and by alternately inserting the first and second portions between the free ends of the two vibrating arms, displacements in opposite directions can also be applied to the two vibrating arms.

For a better understanding of the invention, embodiments will now be described, by way of example, with reference to the accompanying drawings, in which:-

Fig. 1 is a conceptual view of Embodiment 1 of the present invention, the view schematically showing the structure of a power generator using a piezoelectric substance and a portable device equipped with the power generator.

Fig. 2 is a sectional view schematically showing the structure of the piezoelectric power generator shown in Fig. 1.

Fig. 3 is a perspective view of the piezoelectric power generator, shown in Fig. 1, using a vibrating arm.

Fig. 4 is a sectional view showing the structure of the vibrating arm shown in Fig. 3.

Fig. 5 is a graph showing change in the coupling coefficient with respect to a relative thickness of a support layer of the vibrating arm, shown in Fig. 3, which includes piezoelectric portions.

Fig. 6 is a graph showing change in the charging efficiency depending on an initial vibration voltage when the piezoelectric power generator shown in Fig. 3 is used for charging.

Fig. 7 is a graph showing change in the energy loss rate depending on an amplitude in the piezoelectric power generator, shown in Fig. 3, using the vibrating arm which includes the piezoelectric portions.

Fig. 8 is a perspective view schematically showing a power generator according to a second embodiment of the present invention, the power generator using a vibrating arm which includes piezoelectric portions.

Fig. 9 is a perspective view schematically showing a power generator according to a third embodiment of the present invention, the power generator using a vibrating arm which includes piezoelectric portions.

Fig. 10 is a perspective view schematically showing a power generator according to a fourth embodiment of the present invention, the power generator using a vibrating arm which includes piezoelectric portions.

Fig. 11 is a perspective view schematically showing a power generator according to a fifth embodiment in which vibrating arms are combined into the form of a tuning fork.

Fig. 12 is a graph showing self-attenuation of strain energy in the vibrating arm including the piezoelectric portions for each of the different structures.

Fig. 13 is a conceptual view showing one example of a vibration applying mechanism for imparting displacements to the vibrating arms in the form of a tuning fork in opposite directions.

Fig. 14 is a conceptual view showing another different example of the vibration applying mechanism for imparting displacements to the vibrating arms in the form of a tuning fork in opposite directions.

Fig. 15 is a conceptual view showing still another different example of the vibration applying mechanism for imparting displacements to the vibrating arms in the form of a tuning fork in opposite directions.

Fig. 16 is a conceptual view showing still another different example of the vibration applying mechanism for imparting displacements to the vibrating arms in the form of a tuning fork in opposite directions, in which; Fig. 16(a) is a side view and Fig. 16(b) is a bottom view.

### [Embodiment 1]

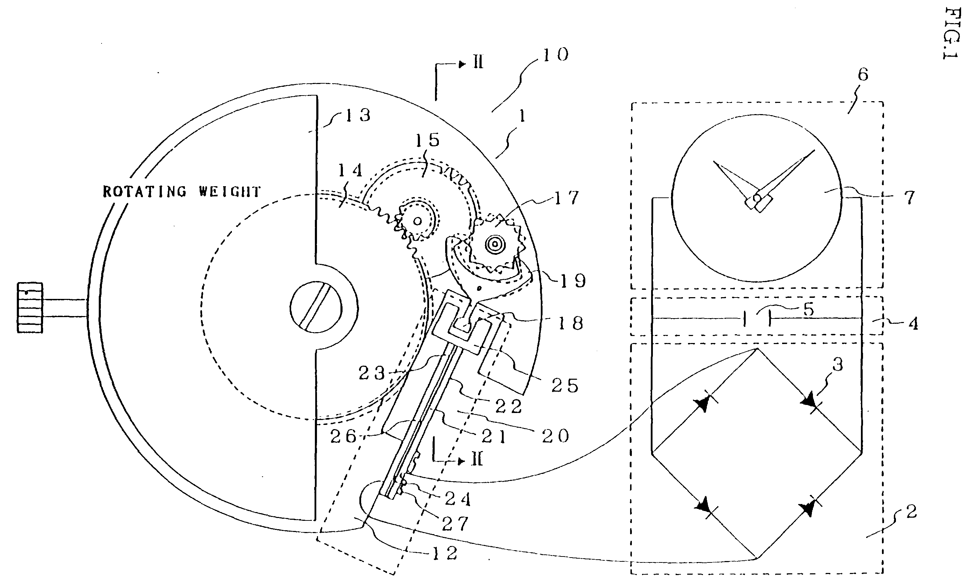

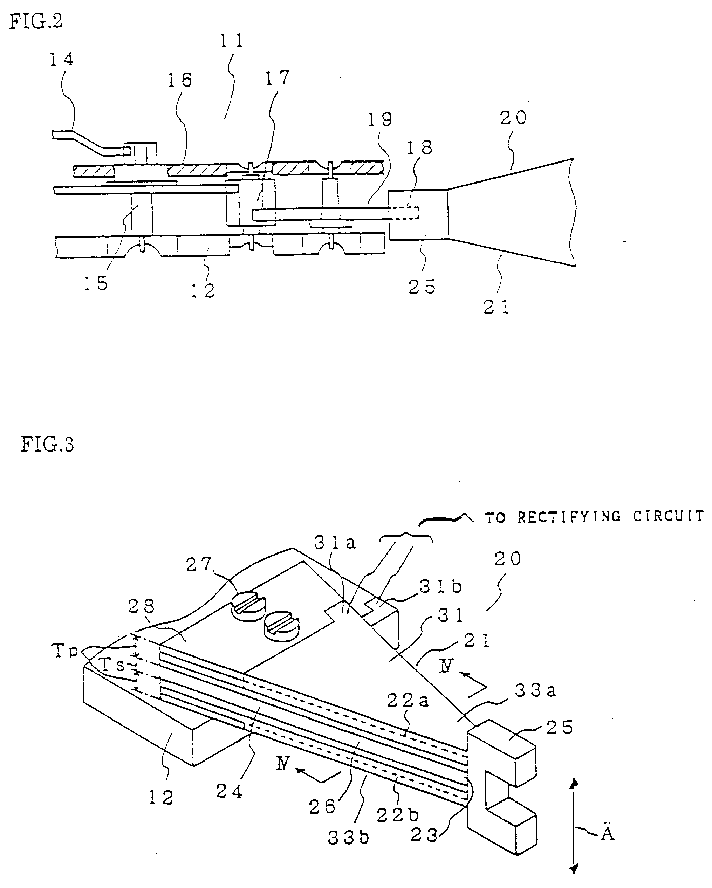

Fig. 1 schematically shows a wrist watch equipped with a piezoelectric power generator according to Embodiment 1 of the present invention. A wrist watch 10 of this embodiment comprises a piezoelectric power generator 20 housed in a case 1, a driving system 11 (Fig. 2) for driving the piezoelectric power generator 20, a rectifying circuit 2 for rectifying an alternating current produced by the piezoelectric power generator 20, an electric condensing circuit 4 for accumulating a rectified current, and a processing unit 6 for carrying out a clocking process based on the generated current. In addition to the clocking process required for driving of a watch section 7 and alarming, the processing unit 6 may of course have a function of a radio, a pager, a personal computer or the like. The electric condensing circuit 4 comprises a condenser or capacitor 5 in this embodiment, but may be a secondary battery or the like which has an electricity accumulating capability. The rectifying circuit 2 is not limited to full-wave rectification using diodes 3 illustrated as this embodiment, but may of course be a half-wave rectifying circuit or a rectifying circuit using inverters. While Fig. 1 shows the wrist watch of this embodiment as a conceptual view, the rectifying circuit 2, the electric condensing circuit 4, the processing unit 6 and so on are actually arranged in vertically superposed relation to the driving system 11, described later, for reducing overall size of the watch.

The piezoelectric power generator 20 used in the wrist watch 10 of this embodiment includes a vibrating arm 21 fixed to a base plate 12 in a cantilevered manner. A piezoelectric portion 22 (22a or 22b) is disposed on each of opposite sides of the vibrating arm 21, these piezoelectric portions 22a and 22b making up a power generating section. Further, a weight 25 is attached to a tip end 23 of the vibrating arm 21, causing the vibrating arm 21 to be vibrated with motion of the weight 25 at the tip end effected by the driving system 11. Specifically, when the driving system 11 is operated to apply vibration, the vibrating arm 21 freely vibrates in such a manner that the tip end of the vibrating arm 21 serves as a free end 23 and an opposite end fixed to the base plate 12 by screws 27 serves as a support end 24. As a result, the piezoelectric portions 22 generate electromotive force.

The driving system 11 in this embodiment includes a rotating weight 13 which is rotatable within the case 1. When the wrist watch is carried on a user, the rotating weight 13 rotates with motion of the user's arm or body and rotating force is utilized to vibrate the vibrating arm 21. To this end, the motion of the rotating weight 13 is transmitted to the weight 25 at the tip end of the vibrating arm 21 through a train of wheels arranged as shown in Fig. 2. First, the motion of the rotating weight 13 is transmitted from a rotating weight wheel 14 to an intermediate wheel 15 while increasing a rotational speed. The intermediate wheel 15 and later-described gears and cam are arranged so as to be able to construct a train of wheels in a narrow space defined within the case 1 between the base plate 12 and a rotating weight receiver 16 supporting the rotating weight 13. Rotation of the intermediate wheel 15 is transmitted to a cam driving wheel 17 which in turn moves a cam 19 to the left and right, thereby swinging a projection 18 of the cam 19 which is laid in a recess of the weight 25 at the tip end of the vibrating arm 21. Accordingly, when rotating force is applied to the rotating weight 13 with the motion of the user's arm or body, the cam 19 is moved to the left and right by the applied force, causing the projection 18 of the cam 19 to hit against the weight 25 of the vibrating arm 21 transversely. This hitting imparts predetermined displacements to the vibrating arm 21 and these displacements are accumulated in the vibrating arm 21 as strain energy. Then, when the cam 19 is returned to the centre, the vibrating arm 21 vibrates so as to produce electromotive force in the piezoelectric portions 22. Incidentally, a ladle-shaped cam having the small moment of inertia is employed as the cam 19 used in the driving system 11 of this embodiment for the purpose of reducing the load of the driving system. Also, the cam driving wheel 17 is additionally employed in combination with the intermediate wheel 15 so that the size of the cam 19 can be reduced.

Fig. 3 schematically shows the structure of the vibrating arm 21 employed in the piezoelectric power generator 20 of this embodiment as viewed from above the vibrating arm 21 in a state that the vibrating arm 21 shown in Fig. 2 is turned 90°. The vibrating arm 21 of this embodiment is a plate-like member having such a substantially trapezoidal shape in its entirety that the free end 23 to which the tip end weight 25 is attached is narrower than the support end 24. The wider support end 24 includes a fixed portion 28 where the vibrating arm 21 is fixed to the base plate 12 by the screws 27. The vibrating arm 21 has a sandwich structure comprising a metallic support layer 26 at the centre and two layers of the piezoelectric portions 22a, 22b on both sides. An electrode 31 is disposed in each surface of the vibrating arm 21 over a region from a location on the side of the support end 24 contacting the base plate 12 to the free end 23. Since the vibrating arm 21 of this embodiment is vibrated by the projection 18 of the cam hitting against recessed inner walls of the channel-shaped weight 25 at the arm tip end, the direction of the vibration is vertical in Fig. 3 as indicated by arrow A. Then, because of having the plate-like form which is wide in a direction perpendicular to the direction of the vibration, the vibrating arm 21 of this embodiment has a structure being relatively pliable in the direction of the vibration, but relatively hard in the direction perpendicular to the direction of the vibration. Therefore, corresponding to a strain in the vertical direction A applied from the cam 19, stable vibration in the vertical direction A is excited in the vibrating arm 21.

In the vibrating arm 21 of this embodiment, the piezoelectric portions 22a and 22b are disposed on both sides of the support layer 26 and are each extended from the free end 23 toward the support end 24 until covering the fixed portion 28. Accordingly, a root portion of the vibrating arm 21 which undergoes a maximum strain is covered by the piezoelectric portions 22a and 22b so that strain energy produced in the root portion can be converted into electric energy by the piezoelectric portions 22a and 22b. Therefore, even if the vibrating arm 21 is in the beam-like form having the same self-attenuation rate as conventionally used, it is possible to increase electric energy taken out per stroke of displacement and to improve the conversion efficiency. The root portion of the vibrating arm 21 extending from the fixed portion 28 on the side of the support end 24 toward the free end 23 represents a region where the vibration leakage tends to easily occur and strain energy is liable to leak. Thus, in the piezoelectric power generator of this embodiment, the piezoelectric portions 22a and 22b are disposed in the region through which a large amount of energy leaks so that stain energy accumulated in that region can be utilized by the piezoelectric portions 22a and 22b. Additionally, strain energy accumulated in the support layer 26 can also be utilized for conversion into electric energy. As a result, the conversion efficiency can be improved to a large extent.

Further, the vibrating arm 21 in the piezoelectric power generator of this embodiment is formed to have a larger width on the side of the support end 24. Therefore, the piezoelectric portions 22a and 22b each have a larger cross-sectional area as they approach the root portion which undergoes a maximum strain, so that the piezoelectric portions can exhibit a power generating capability almost uniform over the entire vibrating arm. Stated otherwise, in the vibrating arm of this embodiment, the amount of strain caused upon vibration of the vibrating arm is gradually increased in a direction from the free end 23 toward the support end 24, while the cross-sectional area of the vibrating arm is also gradually increased in the direction from the free end 23 toward the support end 24. Accordingly, stresses occurred in the vibrating arm are substantially equal in every cross-section and any part of the piezoelectric portions has an almost uniform power generating capability. As a result, variations in distribution of electric charges and electromotive voltage are reduced and efficient power generation is achieved.

Moreover, since the piezoelectric portions 22a and 22b are each formed so as to extend from the free end 23 toward the support end 24 including the fixed portion 28, stresses are not concentrated on edges of the piezoelectric portions and can be dispersed all over the piezoelectric portions. Consequently, it is possible to alleviate concentration of stresses on parts of the piezoelectric portions and to prevent a trouble such as peeling-off of the piezoelectric portions.

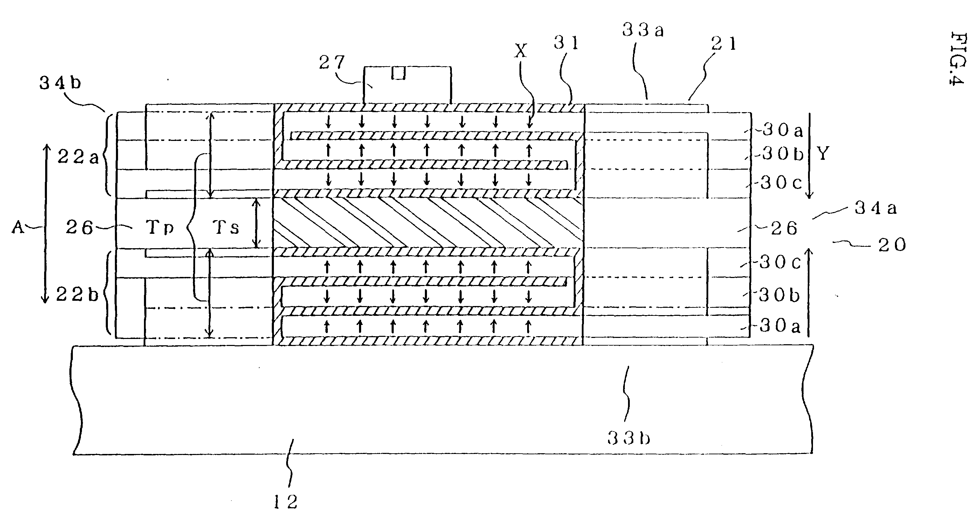

In this embodiment, as shown in Fig. 4, each of the piezoelectric portions 22a and 22b has a layered structure comprising three piezoelectric layers 30a, 30b and 30c laminated in the direction of the vibration. These three piezoelectric layers 30a, 30b and 30c are arranged to be polarized in opposite directions as indicated by arrows X so that the three piezoelectric layers 30a, 30b and 30c are easily connected in parallel through the electrodes 31. Further, the directions of polarization of the piezoelectric layers are selected such that the upper and lower piezoelectric portions 22a and 22b are individually polarized as a whole in opposite directions as indicated by arrows Y with the support layer 26 therebetween. The upper and lower piezoelectric portions 22a and 22b are connected in series through the conductive metallic support layer 26.

In the vibrating arm 21 of this embodiment, the piezoelectric portion 22a above the support layer 26 is compressed and the piezoelectric portion 22b below the support layer 26 is tensioned, by way of example, upon the vibration in the vertical direction A. Accordingly, the vibrating arm 21 of this embodiment generates electric power by utilizing the transverse effect wherein elastic waves propagate in a direction perpendicular to the direction Y of the polarization in which voltage is produced. Since the piezoelectric portions 22a and 22b are attached respectively to the upper and lower sides of the support layer 26 as viewed in the direction of vibrations, the vibrating arm 21 serves as a piezoelectric power generating device of bimorph type.

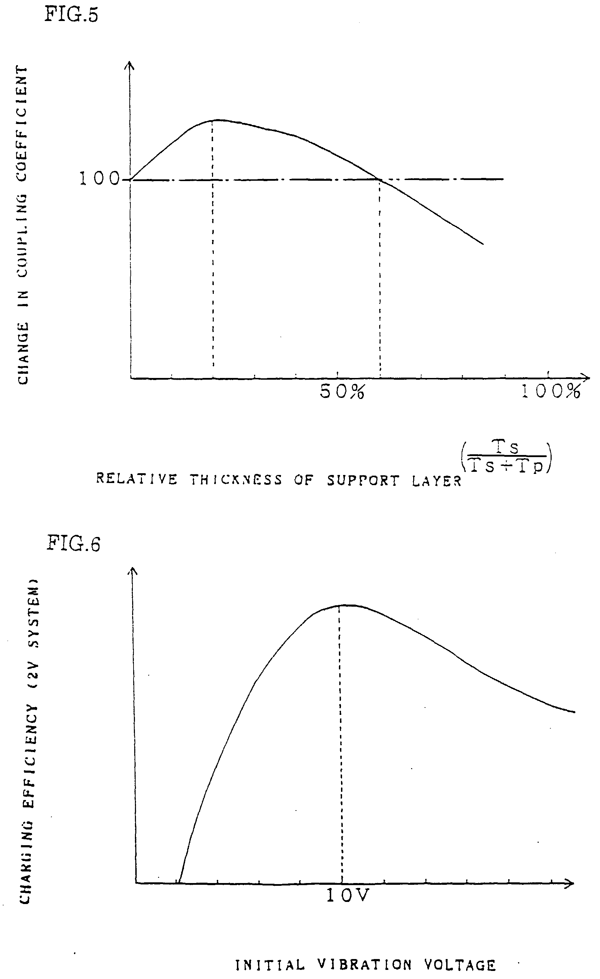

As will also be seen from Fig. 4, in the vibrating arm 21 of this embodiment, the thickness of the support layer 26 is selected to be not larger than 60%, preferably about 20%, of the total thickness of the vibrating arm 21. Stated differently, a ratio of the thickness Ts of the support layer 26 to the total thickness Tp of the piezoelectric portions 22a and 22b is selected to be 1:1 or below. In other words, a ratio of the cross-sectional area of the support layer 26 to the total cross-sectional area of the piezoelectric portions 22a and 22b is selected to be 1:1 or below. Fig. 5 is a graph showing change in the electro-mechanical coupling coefficient (hereinafter referred to simply as coupling coefficient) with respect to a relative thickness of the support layer 26 of the vibrating arm wherein the support layer 26 is made of copper bronze and the piezoelectric portions 22a and 22b are made of PZT (trade name) as one of ceramic-base piezoelectric materials. The coupling coefficient represents the electro-mechanical conversion efficiency of a piezoelectric transducer and, in this embodiment, it is expressed by a square root of the ratio of energy mechanically input to energy electrically output after conversion.

As will be seen from Fig. 5, the coupling coefficient is maximized when the relative thickness of the support layer is about 20%, and is gradually reduced as the relative thickness increased from 20%. Then, when the relative thickness reaches about 60%, the vibrating arm shows the coupling coefficient comparable to that of the vibrating arm wherein the support layer 26 is not present, i.e., the piezoelectric portions 22a and 22b are directly connected to each other. At the relative thickness of the support layer exceeding about 60%, the coupling coefficient is almost monotonously reduced. From the above experiment results, it is understood that the relative thickness of the support layer 26 is desirably kept within about 60% of the total thickness of the vibrating arm. It is also understood that the relative thickness of the support layer 26 is desirably selected to be about 20% for increasing the coupling coefficient and realizing the vibrating arm with higher conversion efficiency. Thus, the thickness of the support layer is desirably held in the above-mentioned range because it is thought that if the support layer is too thick, strain energy accumulated in the support layer is increased and the percentage of the strain energy converted into electric energy in the piezoelectric portions is reduced. On the other hand, when the support layer is not present, strain energy is all accumulated in the piezoelectric portions and hence the conversion efficiency is increased. However, probably due to other factors to be taken into consideration for practical use, such as efficiency of accumulating given impact force as strain energy and attenuation of the vibration, the vibrating arm including the thin support layer provides higher conversion efficiency.

Continuing to discuss the structure of the vibrating arm 21, since the support layer 26 of metal or the like held between the piezoelectric portions 22a and 22b is positioned nearly at the centre that undergoes no appreciable strain, most of the mechanically input energy is accumulated in the piezoelectric portions 22a and 22b. More specifically, supposing the condition where the vibrating arm 21 is displaced, parts of the vibrating arm which are close to its upper and lower surfaces, including the piezoelectric portions 22a and 22b, are subject to large displacements, whereas parts of the vibrating arm which are close to the centre, including the support layer 26, are subject to small displacements. Accordingly, it is thought that the support layer having the relative thickness in the above-mentioned range provides positive or advantageous contribution such as converting strain energy into vibrations in a larger amount than negative or disadvantageous contribution of absorbing the strain energy. It is thus thought that the support layer having an appropriate thickness is effective to increase electric energy generated per cycle of vibration and hence can improve the conversion efficiency. In many cases, energy is input to the vibrating arm 21 through an impact applied by a movable member such as a rotating weight and, therefore, a piezoelectric transducer would easily be damaged if it is used to form the surface undergoing such an impact. Additionally, since piezoelectric transducers widely employed nowadays are made of ceramic-base materials, the impact directly applied to the vibrating arm is desirably as small as possible. From that point of view, the piezoelectric power generator of this embodiment is advantageous in that the support layer 26 can be made of such metal or the like as being hard to break, and mechanical energy can be input to the vibrating arm 21 through the support layer 26. It is also possible to employ the conductive support layer 26 for electrical connection with the piezoelectric portions disposed on both sides thereof. To prevent troubles caused by the impact, in the vibrating arm 21 of this embodiment, the weight 25 is attached to the arm tip end and the driving system 11 applies a hit against the weight 25 so that the impact will not directly be applied to the piezoelectric portions.

Moreover, in the vibrating arm 21 of this embodiment, each of the piezoelectric portions 22a and 22b is constructed by laminating the three piezoelectric layers 30a, 30b and 30c. Then, these three piezoelectric layers 30a, 30b and 30c are connected in parallel through the electrodes 31. Accordingly, each of the piezoelectric portions 22a and 22b has an electrode surface three times and hence an capacitance nine times as large as that obtainable with the case of not laminating the piezoelectric layers, but the electromotive voltage in the open condition is reduced down to 1/3. Further, since laminating the piezoelectric layers contributes to increasing the thickness of the piezoelectric portions, the relative thickness of the support layer can be lessened easily.

Additionally, in the vibrating arm 21 of this embodiment, the directions of polarization Y of the individual piezoelectric portions 22a and 22b are opposite to each other as a whole, and the piezoelectric portions 22a and 22b are connected in series through the support layer 26. As a result, the electromotive voltage of the vibrating arm 21 is twice that in the case of the piezoelectric portions having the same direction of polarization.

In the power generator using a piezoelectric transducer, electric energy generated upon application of a strain to the piezoelectric transducer is determined by only the electro-mechanical coupling coefficient when it is not used for charging. Stated otherwise, any types of piezoelectric transducers generate electric energy in the same amount from the same input energy if they have the same electro-mechanical coupling coefficient. But the electric energy stored in an electric condensing circuit such as a condenser through charging is given by a function of the electromotive voltage and capacitance of the piezoelectric transducer, the voltage of the electric condensing circuit such as a condenser, as well as the electro-mechanical coupling coefficient. For example, a system including an electric condensing circuit cannot be charged by using such a power generator as having a large capacitance, but an electromotive voltage lower than the electric condensing circuit. On the other hand, if a power generator that has a capacitance infinitely close to zero, but an electromotive voltage close to infinity is employed, no appreciable charges are produced and the amount of charging is so small that the system including the electric condensing circuit cannot be charged in practice. It is therefore important to find optimum values of the electromotive voltage and the capacitance for charging between the above two extreme conditions.

As a result of experiments and studies, the inventors have confirmed that the amount of charging is maximized when the electromotive voltage of the power generator using a piezoelectric transducer is about twice the voltage of the electric condensing circuit. For example, when charging is made in a system of total 2 V in which the voltage of the condenser 5 shown in Fig. 1 is 1.5 V and the voltage loss of the diodes used in the rectifying circuit is 0.5 V, it is desirable for the power generator to have an electromotive voltage of 4 V. Further, in the power generator using a vibrating arm, the electromotive voltage produced by initial vibration is maximum and then gradually reduced as vibrations attenuate. Accordingly, the initial electromotive voltage is desirably set so as to provide the maximum amount of charging.

Fig. 6 is a graph showing a relationship between charging efficiency and an initial vibration voltage when a 2V charging system is charged. As will be seen from Fig. 6, for the 2V charging system, the power generator is desirably set so as to provide an initial vibration voltage of 10 V. Thus, in order to increase a current generating capability of power generators having the same capability of accumulating electric energy, that one must have a large capacitance on one hand and is required to have an appropriate initial electromotive voltage on the other hand.

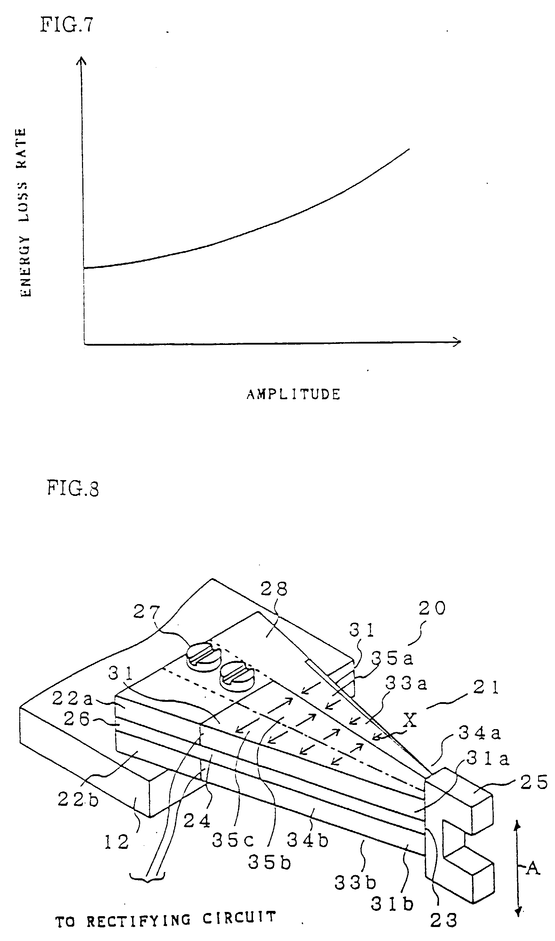

Furthermore, in the power generator using a vibrating arm, a high initial electromotive voltage can be obtained by increasing an initial displacement. As shown in Fig. 7, however, the larger an amplitude, the larger is a vibration energy loss rate and, therefore, the smaller is the total amount of charging. Accordingly, it is desirable that the power generator has an appropriate initial electromotive voltage while keeping the amplitude as small as possible.

In the power generator using the vibrating arm of this embodiment, the piezoelectric portions 22a and 22b are each of the laminated structure to increase the capacitance for producing a large output current. Further, the piezoelectric portions 22a and 22b are connected in series to hold a high initial electromotive voltage so that the predetermined initial electromotive voltage can be obtained even with a small amplitude. In other words, with the power generator of this embodiment employing the laminated structure, values of the capacitance and the electromotive voltage can be optimized. As a result, a piezoelectric power generator having increased conversion efficiency and high charging performance can be realized.

While this embodiment is illustrated as having the laminated structure of three layers, the number of laminated layers can freely be set in consideration of the voltage of the electric condensing circuit, the size and displacement of the vibrating arm, etc. so as to provide the power generator having the piezoelectric portions which have an optimum structure for charging. Further, the power generator of this embodiment has an advantage of enabling the capacitance of the piezoelectric portions to be changed and optimized without modifying the size of the vibrating arm. As explained above, the number of laminated layers or the capacitance is a matter of choice in design to provide an optimum structure, taking into account various factors such as the size and method of the input mechanism and the voltage of the charging circuit. Meanwhile, a portable electronic device has in fact limitations in the size of its power generating section and difficulties in modifying the size of the power generating section to adjust the capacitance. However, these problems can be solved by employing the power generator of this embodiment. Additionally, the problem that a piezoelectric transducer has difficulties in taking out a lot of charges because it inherently exhibits a large voltage and a small capacitance, can also be solved.

Further, as shown in Fig. 3, the power generator of this embodiment is arranged such that the electrodes 31 covering the piezoelectric portions 22a and 22b are extended from the free end 23 toward the support end 24 of the vibrating arm 21 similarly to the piezoelectric portions 22a and 22b and are terminated in somewhat overlapped relation to the fixed portion 28 of the vibrating arm 21. The electrodes 31 can be provided in the whole portion of the vibrating arm 21, not only over the piezoelectric portions 22a and 22b but the fixed portion 28. But in this embodiment, the electrodes 31 are not present on the fixed portion 28 for a reason as follows.

Since the vibrating arm 21 is fixed to the base plate 12 through the fixed portion 28, no strains occur in the fixed portion 28 and the piezoelectric portions located in the fixed portion 28 will not contribute to the generation of electric power. If the electrodes 31 are provided so as to cover even parts of the piezoelectric portions which will not contribute to the power generation, charges produced in parts of the piezoelectric portions which will contribute to the power generation would be distributed uselessly, resulting in a drop of the electromotive voltage. In this embodiment, therefore, only the parts of the piezoelectric portions which will contribute to the power generation are covered by the electrodes 31 so that the power generator can keep a high voltage without reducing the electromotive voltage. As described above, since the power generator of this embodiment can provide a large capacitance and a sufficiently high electromotive voltage, it is possible to diminish displacements of the vibrating arm and to reduce an amplitude of the vibration. Consequently, initial stress caused in the vibrating arm is reduced and, as a result, a piezoelectric power generator in which the vibrating arm has improved durability and stable power generation is ensured for a long term can be provided.

In this embodiment, part of one electrode 31 which is exposed to the upper surface of the vibrating arm is extended to form a terminal 31a for connection to the rectifying circuit. Also, part of the other electrode 31 which is exposed to the lower surface of the vibrating arm is held in contact with the base plate 12 through which the electrode is connected to a terminal 31b for connection to the rectifying circuit. Thus, in the power generator of this embodiment, the electric energy generated by the piezoelectric portions is taken out through output leads provided in part of the vibrating arm which is less subjected to vibrations of the piezoelectric portions, i.e., on the side of the support end 24 opposite to the free end 23, particularly in the fixed portion 28. This is because if lead wires are connected to vibrating parts of the piezoelectric portions, the vibration leakage through the leads would probably occur. By taking out the generated electric power from the side of the support end 24, particularly the fixed portion 28, like this embodiment, the vibration leakage caused by the output leads can be prevented nearly completely.

Moreover, in the vibrating arm 21 of this embodiment, the piezoelectric portions 22a and 22b on both sides of the support layer 26 are formed by depositing laminated layers on the support layer 26 with such techniques as vapour deposition or sputtering. Accordingly, unlike a power generator wherein piezoelectric portions are attached to the support layer 26 by using an adhesive or the like, the power generator of this embodiment can avoid the disadvantages that the adhesive would serve as a buffer member to reduce the strain applied to the piezoelectric portions and produce energy loss therein through adverse effects of the adhesive depending on its thickness, hardness and so on. Therefore, a strain of the support layer is efficiently transmitted to the piezoelectric portions for an improvement in the conversion efficiency. Additionally, since no fears of differences in adhesion strength and position shifts are present and factors causing variations in thickness and width of the vibrating arm or beam are reduced, the vibrating arm having good symmetry and a small self-attenuation rate can be mass-produced stably. The cost efficiency is also improved.

It is a matter of course that the driving system for applying an initial displacement to the vibrating arm is not limited to the illustrated system using the rotating weight. The driving system has no particular limitations so long as it can apply strain energy to the vibrating arm of the power generator, and may be of, e.g., a spring itself, a swing member using a spring, a pendulum, or a hammer. Incidentally, any driving system is desirably as small and light as possible to be suitable for use in portable devices.

### [Embodiment 2]

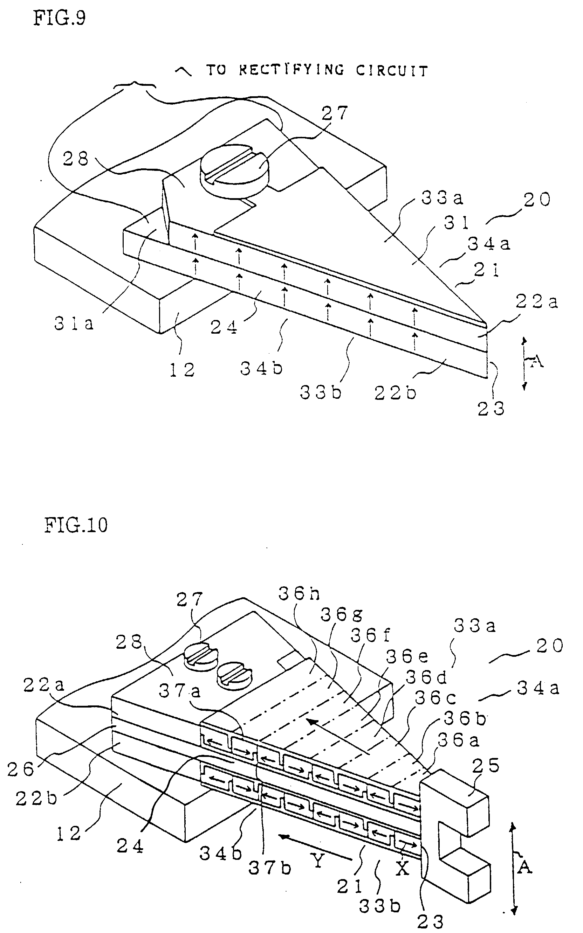

Fig. 8 shows a piezoelectric power generator using a vibrating arm according to another different embodiment of the present invention. A vibrating arm 21 in a piezoelectric power generator 20 of this Embodiment 2 is of bimorph type as with Embodiment 1. Common parts in Embodiments 1 and 2 are denoted by the same reference numerals and will not be described below. In the vibrating arm 21 of this embodiment, piezoelectric portions 22a and 22b disposed on both sides of a support layer 26 have directions of polarization indicated by arrows X that are aligned with the widthwise direction of the vibrating arm 21 and substantially perpendicular to the direction A of vibrations. Accordingly, a voltage is produced in the direction toward left and right lateral surfaces 34a and 34b of the vibrating arm in this embodiment, whereas a voltage is produced in the direction toward upper and lower surfaces 33a and 33b of the vibrating arm in the above Embodiment 1. In the vibrating arm 21 of this embodiment, therefore, electrodes 31a and 31b for connection to the rectifying circuit are provided on one lateral surface 34b, and an electrode for connecting the piezoelectric portions 22a and 22b in series is provided on the other lateral side 34a not appearing in Fig. 8. Also in the power generator of this embodiment, since the direction of propagation of elastic waves occurred with vibrations is perpendicular to the direction of generated voltage, electric power is generated by utilizing the transverse effect of a piezoelectric transducer.

The piezoelectric portions 22a and 22b of the vibrating arm 21 of this embodiment each comprise three layers 35a, 35b and 35c as with the power generator of Embodiment 1. In the power generator of this embodiment, since each piezoelectric portion is polarized in the widthwise direction, i.e., the left-and-right direction, of the vibrating arm 21, the three layers 35a, 35b and 35c are laminated in the left-and-right direction perpendicular to the direction A of vibrations, whereas the three layers are laminated in the vertical direction, i.e., the direction A of vibrations, in the above Embodiment 1. The three layers 35a, 35b and 35c are connected in parallel through electrodes 31. Further, the directions of polarization of the individual piezoelectric portions 22a and 22b are opposite to each other as a whole, and the piezoelectric portions 22a and 22b are connected in series through the electrode similarly to Embodiment 1.

With the power generator 20 of this embodiment thus constructed, since the piezoelectric portions are extended to a root portion of the vibrating arm 21 as with Embodiment 1, there can be realized a piezoelectric power generator in which strain energy of the vibrating arm 21 is effectively converted into electric energy with high conversion efficiency. Also, since the piezoelectric portions 22a and 22b are each of the laminated structure, the capacitance and the electromotive voltage can easily be optimized and the electric condensing circuit can efficiently be charged. Further, since the electrodes 31 are disposed in only parts of the piezoelectric portions which will actually contribute to the power generation, the electromotive voltage can be kept sufficiently high and a satisfactory level of electric power can be ensured with a small amplitude. In additional points such as having high durability, the power generator of this embodiment can also provide similar advantages as obtainable with that explained as Embodiment 1.

### [Embodiment 3]

Fig. 9 shows a piezoelectric power generator according to still another different embodiment of the present invention with a focus centered on a vibrating arm. A piezoelectric power generator 20 of this Embodiment 3 includes an almost triangular vibrating arm 21 which is constructed by joining two layers of piezoelectric portions 22a and 22b to each other. Further, the piezoelectric portions 22a and 22b are each polarized in the same direction A of vibrations, i.e., in the upward direction. Therefore, a potential having the same polarity is produced in each of upper and lower surfaces 33a and 33b of the vibrating arm of this embodiment. This means that the piezoelectric portions 22a and 22b are connected in parallel through an electrode 31a provided at the interface between the piezoelectric portions 22a and 22b. Accordingly, lead wires for supplying generated electric power to the rectifying circuit therethrough is connected to the electrode 31a provided at the interface between the piezoelectric portions 22a and 22b. Further, electrodes 31 are provided on the upper and lower surfaces 33a and 33b of the piezoelectric portions 22a and 22b and are electrically connected to a screw 27 by which the vibrating arm is fixed to the base plate 12, thereby connecting the electrodes on the upper and lower surfaces 33a and 33b to each other. Then, the generated electric power is also supplied to the rectifying circuit through the base plate 12.

With the power generator 20 of this embodiment, electric power is generated by effectively utilizing a root portion of the vibrating arm 21 which undergoes maximum strain energy, resulting in high conversion efficiency as with the foregoing embodiments. Also, since each of the piezoelectric portions, i.e. each of the sides compressed and tensioned upon vibrations, is formed of a piezoelectric material alone, the total amount of strain energy applied to the piezoelectric transducer per cycle of vibration is easily increased in comparison with a piezoelectric transducer of unimorph type wherein one piezoelectric layer is jointed to a support layer of metal or the like. Consequently, it can be said that the power generator of this Embodiment has the structure capable of easily realizing an efficient piezoelectric power generator which can convert a larger amount of mechanical energy into electric energy per cycle of vibration.

Further, since the two piezoelectric portions 22a and 22b can be formed by depositing piezoelectric layers on both sides of the electrode 31a by sputtering or the like without bonding them to each other using an adhesive, energy loss otherwise caused by an adhesive layer can be prevented. The conversion efficiency can also be improved from this point of view. Additionally, since no fears of differences in adhesion strength and position shifts are present and factors causing variations in thickness and width of the vibrating arm or beam are reduced, the vibrating arm having a small self-attenuation rate can be mass-produced inexpensively.

Like the power generator 20 illustrated as this embodiment, a piezoelectric power generator capable of producing a satisfactory electromotive voltage can be provided without attaching any weight at the free end 23 of the vibrating arm, when a sufficiently high level of electromotive voltage is produced from characteristics of piezoelectric transducers making up the piezoelectric portions and a charging voltage of the electric condensing circuit is low. Further, in the case of not requiring a so large generated current, a satisfactory capacitance can be ensured by connecting the two piezoelectric portions 22a and 22b in parallel with no need of laminating piezoelectric layers.

A vibrating arm of the type illustrated in Fig. 9 may be used in the piezoelectric power generator of Embodiment 2.

### [Embodiment 4]

Fig. 10 shows a piezoelectric power generator using a vibrating arm according to still another different embodiment of the present invention. A vibrating arm 21 in a piezoelectric power generator 20 of this Embodiment 4 is of bimorph type as with Embodiment 1. Common parts in Embodiments 1 and 4 are denoted by the same reference numerals and will not be described below. In the vibrating arm 21 of this embodiment, each of piezoelectric portions 22a and 22b disposed on both sides of a support layer 26 comprises eight piezoelectric layers 36a to 36h laminated in a direction from a free end 23 to a support end 24 of the vibrating arm. The piezoelectric layers 36a to 36h have directions of polarization indicated by arrows X that are aligned with the direction interconnecting the free end 23 and the support end 24 of the vibrating arm 21 and are substantially perpendicular to the direction A of vibrations. Accordingly, a voltage is produced in one of the directions toward the free end 23 and the support end 24, and the piezoelectric layers 36a to 36h are connected in parallel through electrodes 37a and 37b alternately projecting downwardly and upwardly in the form of comb teeth. Then, the directions of polarization Y of the individual piezoelectric portions 22a and 22b are set as a whole such that generated potentials are opposite to each other, and the piezoelectric portions 22a and 22b are connected in series through the conductive support layer 26.

The vibrating arm 21 of this embodiment also vibrates in the vertical direction A as with the vibrating arms of the foregoing embodiments. Therefore, the piezoelectric portions 22a and 22b produce elastic waves propagating in the direction interconnecting the free end 23 and the support end 24. Since the direction of polarization representing the direction of generated voltage is also aligned with the direction interconnecting the free end 23 and the support end 24, the power generator 20 of this embodiment can generate electric power by utilizing the longitudinal effect of piezoelectric transducers. The electro-mechanical coupling coefficient resulted when utilizing the longitudinal effect is nearly three times as large as when utilizing the transverse effect. Therefore, the conversion efficiency of the power generator 20 of this embodiment can be increased to a large extent. Although it is of course possible to employ a single-layer piezoelectric portion for power generation utilizing the longitudinal effect, the use of a single-layer piezoelectric portion would result in a very long distance between electrodes and a too small capacitance to produce a lot of charges. Accordingly, in spite of an improvement in the conversion efficiency, there is a difficulty in realizing a piezoelectric power generator usable for practical charging. By contrast, in the power generator of this embodiment, since the electromotive voltage and the capacitance are optimized by employing the laminated structure, electric energy produced per cycle of vibration is increased and charging can effectively be performed with high conversion efficiency.

As with the foregoing embodiments, in the power generator 20 of this embodiment, the piezoelectric portions are extended to a root portion of the vibrating arm 21 so that strain energy in the root portion of the vibrating arm 21 can also efficiently be converted into electric energy. Further, since the piezoelectric portions 22a and 22b each have the laminated structure, the electromotive voltage and the capacitance can easily be optimized. Thus, the power generator 20 of this embodiment can provide various advantages similar to those obtainable with the foregoing embodiments. In addition, since the piezoelectric layers are laminated in the direction from the free end toward the support end of the vibrating arm, a piezoelectric power generator having very high conversion efficiency by utilization of the longitudinal effect can be realized. In this embodiment, however, the piezoelectric layers cannot be formed continuously from the free end to the fixed portion beyond the support end of the vibrating arm.

A vibrating arm of the type illustrated in Fig. 9 may be used in the piezoelectric power generator of Embodiment 4.

### [Embodiment 5]

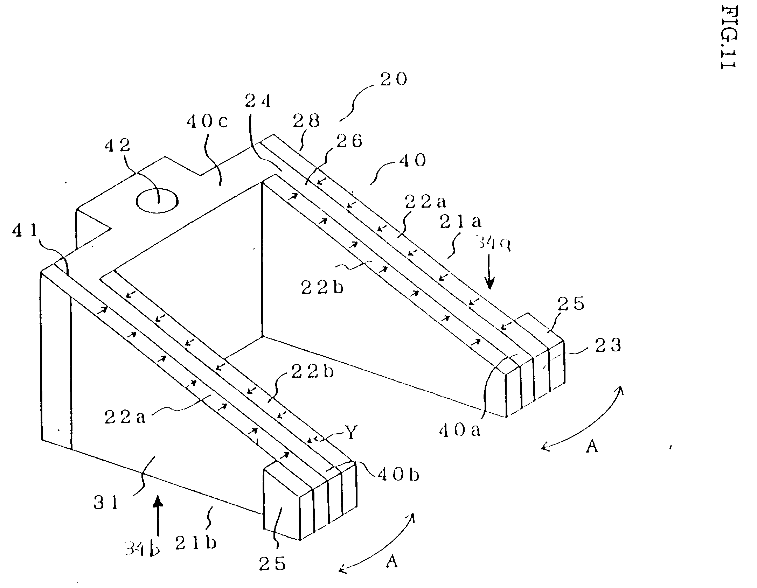

Fig. 11 shows a piezoelectric power generator using a vibrating member according to still another different embodiment of the present invention. In the piezoelectric power generator of this Embodiment 5, electric power is generated by using a vibrating member 40 formed by coupling two vibrating arms 21, each of which is the same as used in the foregoing embodiments.

Efficiency of converting strain energy into electric energy by using the vibrating arm provided with the piezoelectric portions will now be studied in more detail. Vibrations of the vibrating arm 21 are gradually attenuated, even though no electric energy is taken out therefrom, due to self-loss occurred within the vibrating arm itself and vibration leakage through a fixed portion at which the vibrating arm is fixed (hereinafter referred to self-attenuation). Here, the attenuation rate of the strain energy due to the self-attenuation per cycle of vibration is assumed to be a %. Since vibrations of the vibrating arm brings about conversion of strain energy into electric energy through the piezoelectric portions, the strain energy is also attenuated in an amount corresponding to the electric energy taken out. This attenuation rate of the strain energy is assumed to be b %. In other words, per cycle of vibration, strain energy of (a+b) % is lost due to the self-attenuation and the conversion into electric energy, while electric energy of b % is produced. Accordingly, the efficiency of conversion into electric energy is expressed by b/(a+b). It is thus understood that if the vibrating arm has no self-attenuation, 100% of strain energy could be converted into electric energy. It is also understood that keeping the self-attenuation as small as possible is effective for improving the conversion efficiency into electric energy.

Vibrating arms of the type illustrated in fig. 9 may be used in the piezoelectric power generator of Embodiment 5.

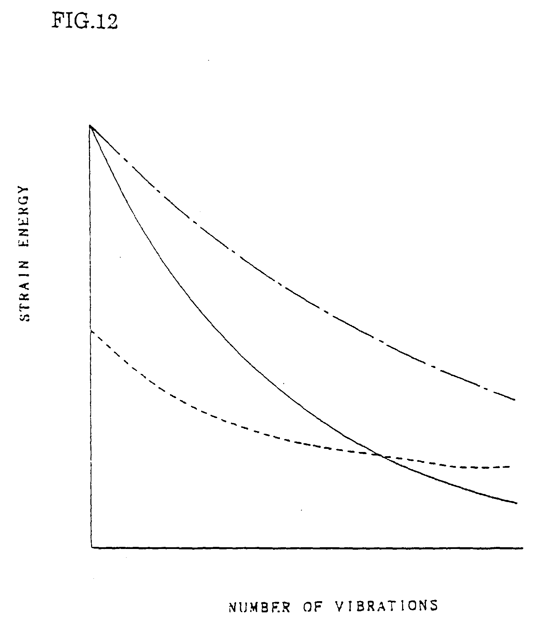

Fig. 12 is a graph showing experimental values indicative of self-attenuation of the strain energy depending on the different structures of vibrating members. In Fig. 12, a solid line represents attenuation of the strain energy resulted when the vibrating arm of cantilevered beam type explained in the above embodiments is displaced and then freely vibrated. In the cantilevered beam, as the number of vibrations increases, the strain energy is almost monotonously reduced in an amount proportional to a square of the amplitude under free vibration. On the other hand, a broken line represents attenuation of the strain energy resulted when normal vibrations are applied to a vibrating member of tuning-fork type. As will be seen from Fig. 12, if only one beam of the tuning fork is displaced in one direction, just nearly a half input energy is employed to develop vibration in a tuning fork mode in which two vibrating arms are vibrated in opposite directions and, therefore, initial strain energy is reduced down to nearly a half that obtainable with the cantilevered beam.

Meanwhile, a one-dot-chain line in Fig. 12 represents attenuation of the strain energy resulted when two vibrating arms 21a and 21b combined into the form of a tuning fork as shown in Fig. 11 are displaced in opposite directions. By so displacing the vibrating arms 21a and 21b in opposite directions, all of input energy is converted into vibrations in the tuning fork mode, enabling the vibrating arms to be vibrated in the tuning-fork vibration mode from the beginning. It is thus understood that, by combining the two vibrating arms into the form of a tuning fork, the self-attenuation is kept very small from the initial stage and the overall self-attenuation of the strain energy in the piezoelectric power generator is considerably reduced. Consequently, the conversion efficiency from strain energy into electric energy can further be improved.

Returning to Fig. 11, the vibrating member 40 of this embodiment will be described below. The vibrating member 40 of this embodiment includes a channel-shaped support member 41 comprising two elongate portions 40a and 40b extending parallel to each other and a bottom portion 40c interconnecting one ends of the elongate portions 40a and 40b. The two vibrating arms 21a and 21b are constructed by using the parallel elongate portions 40a and 40b of the support member 41 as respective support layers. Accordingly, these two vibrating arms 21a and 21b are combined by the coupling portion 40c into the form of a tuning fork so that the vibrating member 40 of this embodiment can excite vibrations in the tuning fork mode. Nearly at the centre of the coupling portion 40c, there is bored a hole 42 through which the vibrating member 40 is fixed to a base plate or the like by a screw.

The vibrating arms 21a and 21b may each be any of the vibrating arms described above. In Fig. 11, by way of example, the vibrating arms 21a and 21b each of which has the same structure as the vibrating arm explained in connection with Embodiment 1 are formed on opposite sides of the channel-shaped support member 40. Because the description of the detailed structure of the above vibrating arm 21 is equally applied to the vibrating arms 21a and 21b, common parts are denoted by the same reference numerals and will not be described below. However, the following is to be noted. Since the vibrating arms 21a and 21b combined into the form of a tuning fork are not separately displaced, a weight 25 attached to a free end 23 of each vibrating arm has a different shape from that in the foregoing embodiments and is positioned on outer lateral surfaces of the tuning- fork type vibrating member 40 so that it can easily receive an impact from the outside. The piezoelectric portions 22a and 22b are each extended from the free end 23 to a support end 24 of the vibrating arm, enabling electric power to be also efficiently generated in a root portion of the vibrating arm which produces large strain energy. Further, the piezoelectric portions 22b positioned on the outer side of the vibrating arms 21a and 21b combined into the form of a tuning fork is extended to the coupling portion 40c of the channel-shaped support member 40 which corresponds to the fixed portion in the aforesaid vibrating arm, thereby preventing such a trouble as peeling-off due to concentration of stresses on the piezoelectric portions. On the other hand, electrodes 31 are formed so as to cover vibrating parts of the piezoelectric portions until the support end 24, not including the coupling portion 40c, so that the electromotive voltage is prevented from dropping due to charges distributing into parts of the piezoelectric portions which will not contribute to the power generation. The positions and configurations of the electrodes 31 are not limited to those shown in Fig. 11, but may be disposed on surfaces 34a or 34b of the vibrating arms 21a and 21b depending on the directions of polarization of the piezoelectric portions 22a and 22b. For example, when the directions of polarization of the piezoelectric portions 22a and 22b are oriented with respect to the direction A of vibrations as with the vibrating arm of Embodiment 2, but differently from this embodiment shown in Fig. 11, electrodes are provided so as to extend following the channel-like shape of the support member 40. The electrodes may have the same configuration on the front and rear sides of the support member 40, or may be modified, for example, such that the electrode on the rear side is formed as a full-surface electrode. In this case, only the two surface electrodes are required to be connected to the rectifying circuit and, therefore, the manufacture is facilitated as compared with the case of connecting four electrodes having the same configuration on the front and rear surfaces of the vibrating arms. Also, since the piezoelectric portions 22a and 22b are connected in series, a large voltage can be produced with a small strain.

Further, the vibrating arms 21a and 21b are each formed into a triangular or trapezoidal shape such that the arm is relatively narrow on the side of the free end 23 and relatively wide on the side of the support end 24, i.e., the root portion, enabling strain energy to be converted into electric energy with high conversion efficiency similarly to the foregoing embodiments. Though not shown in detail, the piezoelectric portions 22a and 22b can each be constructed into the laminated structure of multiple layers, for example, so as to provide similar advantages to those obtainable with the above-explained vibrating arms of cantilevered beam type. The vibrating arms 21a and 21b combined into the form of a tuning fork can be connected in series or in parallel as desired. In the tuning-fork type vibrating member 40 shown in Fig. 11, the channel-shaped support member 41 has conductivity and serves to connect the piezoelectric portions 22a and 22b of each vibrating arm in series at an intermediate potential. Then, the two vibrating arms 21a and 21b are connected in parallel as a whole. Consequently, a piezoelectric power generator having an even larger capacitance can be provided.

The piezoelectric portions 22a and 22b are formed by any of techniques, e.g., sputtering, that need no step of bonding piezoelectric transducers to the support member 40. By forming the piezoelectric portions with such a technique, no fears of differences in adhesion strength and position shifts are avoided in the structure wherein the self-attenuation is affected by symmetry like the tuning-fork type. Also, factors causing variations in thickness and width of each vibrating arm are reduced because the piezoelectric portions may be molded by using a one-piece mold. As a result, the self-attenuation rate can easily be stabilized in mass production. The cost efficiency is also improved.

As explained above with reference to Fig. 12, it is important in the power generator of this embodiment using the tuning-fork type vibrating member that the two vibrating arms 21a and 21b be displaced in opposite directions. If a displacement is applied to only one arm, the vibrating member would vibrate in the tuning-fork vibration mode with just nearly a half input energy and hence the merit of the tuning-fork type of having small self-attenuation could not be developed.

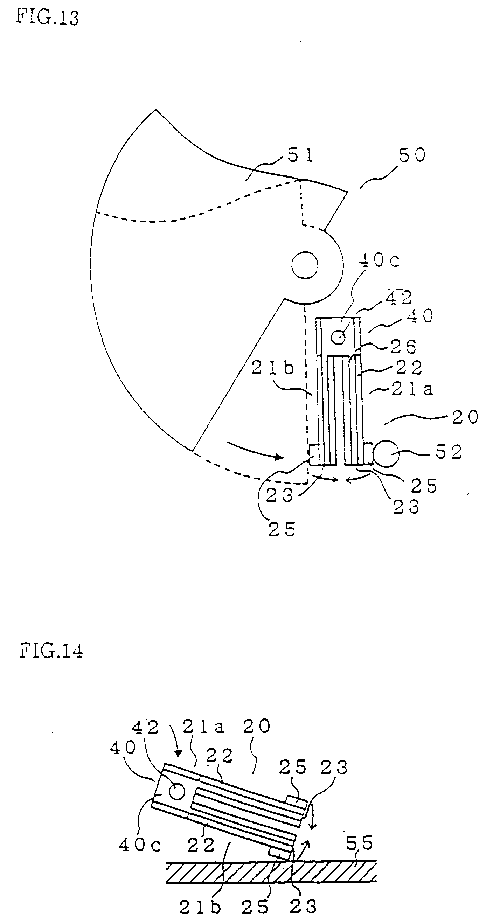

Fig. 13 shows one example of a vibration applying mechanism for applying displacements to the vibrating arms 21a and 21b in opposite directions. A vibration applying mechanism 50 of this example comprises a rotating weight 51 rotatable within a case for use in a wrist watch or the like, and a wall 52 for bearing the vibrating member 40 from the side opposite to the rotating weight 51. The tuning fork-type vibrating member 40 is sandwiched between the rotating weight 51 and the wall 52 so that the vibrating arms 21a and 21b are displaced in opposite directions to vibrate in the tuning-fork vibration mode. When the rotating weight 51 which functions as a weight in the form of a movable member being able to rotate upon application of external force is rotated downwardly or counterclockwise in Fig. 13, one side of the rotating weight 51 hits against the weight 25 at the tip end of the left-hand vibrating arm 21b. The weight 25 at the tip end of the vibrating arm 21a on the opposite side is thereby caused to strike against the wall 52, allowing both the rotating arms 21a and 21b to be displaced inwardly substantially at the same time. When the rotating weight 51 is returned upwardly or clockwise and the free ends 23 of the rotating arms 21a and 21b are released from the impact, the arms start freely vibrating in the tuning-fork vibration mode. Accordingly, the self-attenuation of vibrations of the rotating arms 21a and 21b is very small and strain energy is less wasted. As a result, strain energy can efficiently be converted into electric energy. When the position of a portable electronic device such as a wrist watch is changed again and the rotating 51 is rotated to hit against the vibrating member 40 again, the vibrating member 40 is sandwiched between the rotating weight 51 and the wall 52 to repeatedly cause strains in opposite directions. Therefore, strain energy is input to the vibrating arms 21a and 21b of the vibrating member 40, thereby continuously generating electric power.

As an alternative, the channel-shaped support member 40 may be attached to the base plate in a rotatable manner, and a stop for preventing the rotation of the rotating weight 51 may be provided between the vibrating arms 21a and 21b. While the rotating weight 51 in the above-mentioned example is arranged so as to hit against one of the vibrating arms 21a and 21b, the vibration applying mechanism may be constructed such that the rotating weight 51 hits against the vibrating arms 21a and 21b from both sides for displacing the arms in opposite directions. In this case, the rotation stop is required to be located in the vicinity of both the vibrating arms at a position out of interference with hitting motion of the rotating weight 51.

Fig. 14 shows another different example of the vibration applying mechanism. The tuning-fork type vibrating member 40 of this example is attached in a pivotable manner like a pendulum, and a wall 55 is provided such that when the rotating member 40 is rotated in one direction, the weight 25 at the free end 23 of one of the rotating arms 21a and 21b strikes against the wall 55. When the free end 23 of one rotating arm strikes against the wall 55, that free end 23 is displaced inwardly and, at the same time, the free end 23 of the other rotating arm is also displaced inwardly by virtue of inertia due to its own weight. Accordingly, the free ends 23 of the rotating arms 21a and 21b are both displaced inwardly, i.e., in opposite directions, causing the arms to vibrate in the tuning-fork vibration mode. The wall 55 against which the vibrating member 40 strikes may provided near one of the vibrating arms like this example, or may be provided outwardly of each vibrating arm so that both the vibrating arms strikes against the respective walls to excite vibrations successively. Further, the vibrating member 40 may be arranged to pivot or drop under action of the gravity, or to pivot depending on motion of the user as with the aforementioned rotating weight 51 for use in a wrist watch.

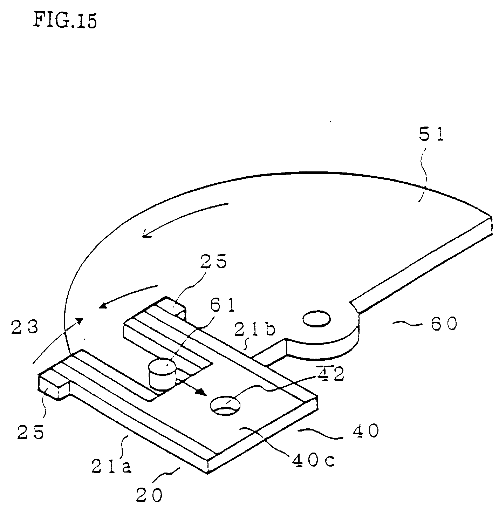

Fig. 15 shows still another different example of the vibration applying mechanism. A vibration applying mechanism 60 of this example is intended to apply a hit to a crotch portion of the tuning-fork type vibrating member 40 for displacing the vibrating arms 21a and 21b in opposite directions. To this end, in the vibration applying mechanism of this example, a projection 61 is provided in an outer peripheral portion of the rotating weight 51 and the vibrating member 40 is arranged such that, when the rotating weight 51 is rotated, the projection 61 strikes against substantially the centre of the coupling portion 40c of the channel-shaped support member 40. Accordingly, upon rotation of the rotating weight 51, an impact is applied to both the vibrating arms 21a and 21b, causing the free ends 23 of the vibrating arms 21a and 21b to displace inwardly. As a result, the arms start vibrations in the tuning-fork vibration mode with less attenuation.

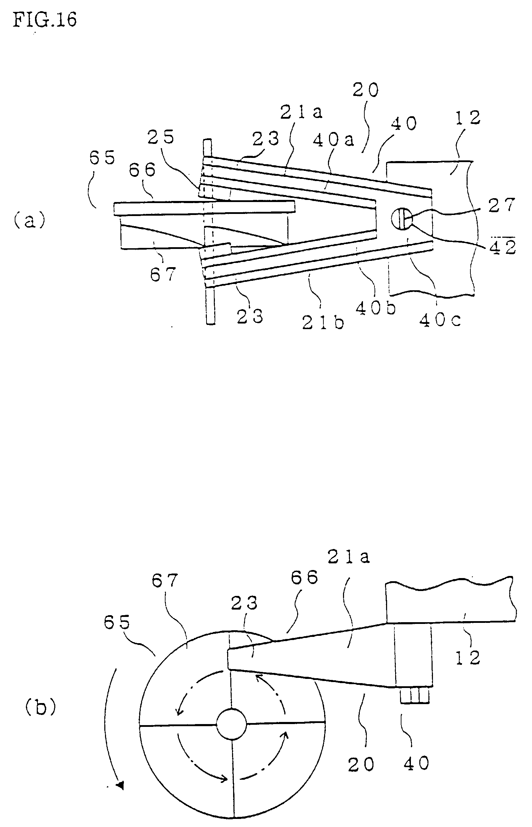

Fig. 16(a) is a side view showing still another different example of the vibration applying mechanism and Fig. 16(b) is a bottom view of the vibration applying mechanism. A vibration applying mechanism 65 of this example includes a disk 66 which rotates between the vibrating arms 21a and 21b combined into the form of a tuning fork. The disk 66 is provided with slopes 67 inclined intermittently or stepwisely. More specifically, the slopes 67 are defined by moderate slopes gradually inclining from a high level to a low level as indicated by arrows of one-dot-chain lines in Fig. 16(b), and steps or steep slopes abruptly inclining from a high level to a low level and located at the boundary between the moderate slopes. Accordingly, when the disk 66 is rotated between the vibrating arms 21a and 21b, the free end 23 of one of the vibrating arms 21a and 21b is moved along the moderate slope 67 from the low level to the high level, thereby increasing the distance between the free ends 23. Then, when the free end 23 passes over the top of the moderate slope 67, it is abruptly shifted from the high level to the level at the step or steep slope on the disk 66, whereupon the vibrating arms 21a and 21b are simultaneously displaced inwardly to start vibrating in the tuning-fork vibration mode. In the vibration applying mechanism 65 of this example which employs the disk provided with the slopes, if the disk 66 or the vibrating member 40 is fixed in such a manner as able to vertically move a little, the two vibrating arms 21a and 21b can be displaced in almost similar fashion. Accordingly, since more uniform vibrations can be developed in the vibrating arms 21a and 21b, there can be excited a vibration mode that provides higher conversion efficiency with less attenuation.

Incidentally, the disk 66 can be rotated by utilizing rotational energy of the rotating weight 51 for use in a wrist watch or the like. It is a matter of course that, rather than rotating the disk provided with the slopes, the vibrating arms 21a and 21b combined into the form of a tuning fork may be moved so as to intermittently displace up and down following the slopes.

The vibration applying mechanisms of Figs. 13, 14, 15, and 16a and b may be used with vibrating arms of the type illustrated in Fig. 9.

While the present invention has been described above in connection with several embodiments, the invention is not limited to those embodiments. For example, while several types of the vibrating arms have been illustrated as embodiments, any of those vibrating arms can be formed into the tuning fork type. In the fork type embodiments, the layers of the piezoelectric portions are formed on both surface of the vibrating member, but may be formed on either one surface of the vibrating member.

In the embodiments, the vibrating arms have been described as being almost trapezoidal or triangular so that strain energy produced in the root portion of the vibrating arm can efficiently be converted into electric energy, but the arm configuration is not limited to a trapezoid or triangle. The conversion efficiency can be increased by employing desired ones of the above-explained structures, e.g., by extending the piezoelectric portions to the root portion of the vibrating arm, or laminating piezoelectric layers in the piezoelectric portions. Further, the piezoelectric layers may not be formed by sputtering employed in the above embodiments, and the vibrating arm can of course be manufactured by using a piezoelectric substance in the bulk form. Additionally, materials of the piezoelectric portions are not limited to PZT (trade name), but may of course be of quartz, ceramic materials such as based on barium titanate and lead titanate, or high molecular materials such as PVDF (Poly Vinylidene Fluoride).

Moreover, the present invention is not limited to a wrist watch described in the above embodiments. Other than a wrist watch, the piezoelectric power generator of the present invention is also applicable to portable electronic devices such as a pager, a telephone, a wireless unit, a hearing aid, a pedometer, a minicalculator, information terminals such as an electronic pocketbook, an IC card, and a radio receiver. By incorporating the piezoelectric power generator of the present invention in those portable devices, an electric condensing device can be charged at all times in conjunction with motion of the user, making it possible to suppress consumption of a battery or eliminate the need of a battery itself. Accordingly, the user can use those portable devices without worrying about the battery becoming flat, and the trouble that data stored in a memory is lost upon power-down of a battery can be prevented. Further, even in areas or places where batteries or charging devices are not easily available, or even under situations where batteries are difficult to replenish due to disasters or the like, the portable electronic devices each having the piezoelectric power generator can continuously develop their normal functions.

According to the piezoelectric power generator, as described hereinabove, since the piezoelectric portions are formed so as to extend to the root portion at the support end of the vibrating arm of cantilevered beam structure, a larger amount of electric energy can be taken out per cycle of vibration, thereby providing a power generator having high conversion efficiency. Since the vibrating arm has a triangular or trapezoidal shape so that relatively large parts of the piezoelectric portions are located on the side of the support end, electric power can be generated by efficiently utilizing strain energy concentrated in the root portion of the vibrating arm. Further, by employing desired one(s) of the above-disclosed structures, e.g., by employing the structure capable of converting mechanical energy into electric energy by utilization of the longitudinal effect, the piezoelectric power generator of the present invention can convert mechanical energy stored in the vibrating arm into electric energy with extremely high efficiency. As a result, the present invention can provide a power generator using a piezoelectric substance which is small in size and can realize incorporation into portable devices.

In the piezoelectric power generator, the piezoelectric portions each have the laminated structure so that the capacitance and the electromotive voltage as important characteristics of the power generator can optimally be set in match with the charging system. Also, those characteristics can optimally be set in the condition suitable for application to small-sized portable devices without changing the size of the power generator. Consequently, a power generator may be provided using a piezoelectric substance which can practically accumulate electric energy in a condenser or the like with high charging efficiency.

Further, self-attenuation of vibrations is also taken into consideration and a piezoelectric power generator with less self-attenuation and high efficiency of conversion into electric energy is realized by combining two vibrating arms into the form of a tuning fork. Then, by imparting displacements in opposite directions to the vibrating arms combined into the form of a tuning fork, the arms can vibrate in the tuning-fork vibration mode from the beginning with less vibration leakage. It is therefore possible to reduce vibration energy loss initially and to generate electric power with higher conversion efficiency.

Thus, according to the present invention, a highly efficient piezoelectric power generator suitable for small-sized portable devices may be realized, and portable electronic devices having various functions and capable of being used safely and positively anytime and anywhere may also be realized by employing the piezoelectric power generator.

## Claims

1. A piezoelectric power generator (20) comprising:
at least one vibrating arm (21) having a free end (23) being able to freely vibrate and a support end (24) for supporting said free end,
at least two piezoelectric portions (22a, b) laminated together, and
electrodes (31) covering at least part of the surfaces of said piezoelectric portions (22a, b),
said vibrating arm or arms (21) including a power generating section capable of outputting an alternating current through said electrode and being formed at least on the side of said support end (24).

2. A piezoelectric power generator according to claim 1, modified in that the at least two piezoelectric portions (22a, b) are laminated with a support layer (26) therebetween, and the percentage of cross-sectional area of said support layer (26) in said power generating section is not larger than substantially 60%.

3. A piezoelectric power generator according to Claim 1 or 2, wherein the size of at least one of said two piezoelectric portions (22a, b) in the widthwise direction, perpendicular to the direction of vibration of said vibrating arm (21), is wider at said support end (24) than at said free end (23).

4. A piezoelectric power generator according to Claim 1, 2 or 3, wherein said vibrating arm (21) includes, at said support end (24), a portion at which said vibrating arm (21) is fixed to a stationary member (12), and a portion extending from the fixed portion toward said free end (23), said piezoelectric portions (22a, b) being provided at least over the fixed portion and the extended portion.

5. A piezoelectric power generator according to Claim 4, wherein said electrodes (31) are provided in the extended portion.

6. A piezoelectric power generator according to Claim 1, 2, 3, 4 or 5, wherein at least one of said two piezoelectric portions (22a, b) comprises first and second piezoelectric parts which are polarized in opposite directions and are connected in series.

7. A piezoelectric power generator according to Claim 1, 2, 3, 4 or 5, wherein at least one of said two piezoelectric portions (22a, b) includes a plurality of piezoelectric layers laminated in the direction of polarization, said piezoelectric layers being connected in parallel.

8. A piezoelectric power generator according to Claim 7, wherein said piezoelectric portions (22a, b) are polarized in a direction substantially perpendicular to the direction interconnecting said free end (23) and said support end (24) of said vibrating arm (21).

9. A piezoelectric power generator according to Claim 7, wherein said piezoelectric portions (22a, b) are polarized substantially in the direction interconnecting said free end (23) and said support end (24) of said vibrating arm (21).

10. A piezoelectric power generator according to any one of the preceding claims, wherein a weight (25) is attached to a tip of said free end (23) of said vibrating arm (21) and said free end is caused to freely vibrate upon an impact applied to said weight.

11. A piezoelectric power generator according to Claim 1, wherein the two piezoelectric portions (22a, b) are polarized in the same direction.

12. A piezoelectric power generator (20) comprising:
two vibrating arms (21a, b) each having a free end (23) being able to freely vibrate and a support end (24) for supporting said free end,
at least two piezoelectric portions (22a, b) disposed on each of said two vibrating arms (21a, b), and
electrodes (31) covering at least parts of surfaces of said piezoelectric portions (22a, b),
each of said two vibrating arms (21a, b) including a power generating section capable of outputting an alternating current through said electrodes (31),
said two vibrating arms (21a, b) being combined into the form of a tuning fork with their support ends (24) coupled to each other.

13. A piezoelectric power generator (20) comprising at least one vibrating arm (21) having a piezoelectric portion (22a, b), an electrode (31) and a power generating section for outputting a current through said electrode, characterised in that the piezoelectric portion (22a, b) and/or the vibrating arm or arms (21) are substantially triangular or trapezoidal in shape.

14. A piezoelectric power generator (20) comprising at least one vibrating arm (21) having a piezoelectric portion (22a, b), an electrode (31), and a power generating section for outputting current through said electrode, characterised in that the electrode (31) is provided only at the end (23) of the vibrating arm which is able to freely vibrate.

15. A piezoelectric power generator according to Claim 12, comprising two piezoelectric power generators as claimed in any one of claims 1 to 11, 13 and 14.

16. A portable power supply unit comprising said piezoelectric power generator according to Claim 12 or 15, and a vibration applying mechanism for imparting displacements in opposite directions to said two vibrating arms (21a, b) combined into the form of a tuning fork.

17. A portable power supply unit according to Claim 16, wherein said vibration applying mechanism comprises a hitting portion (51) for hitting against said free end (23) of one of said two vibrating arms (21a) in a direction toward the other vibrating arm (21b), and a wall portion (52) against which said free end of the other vibrating arm strikes when a hit is applied to said one vibrating arm, and wherein said two vibrating arms combined into the form of a tuning fork are vibrated by being sandwiched between said hitting portion and said wall portion.

18. A portable power supply unit according to Claim 17, wherein said vibration applying mechanism includes a weight moving like a pendulum and said hitting portion hits against one of said vibrating arms with motion of said weight.

19. A portable power supply unit according to Claim 16, wherein said two vibrating arms (21a, b) combined into the form of a tuning fork are supported such that their free ends (23) are movable like a pendulum, said vibration applying mechanism includes a wall portion (55) against which said free end of one of said vibrating arm strikes, and vibrations are applied to said two vibrating arms combined into the form of a tuning fork when said vibrating arms are swung externally and said free end of at least one of said vibrating arms strikes against said wall portion.

20. A portable power supply unit according to Claim 16, wherein said vibration applying mechanism includes a hitting portion (61) for hitting against substantially the centre of a member (40) coupling, on the side of said support ends (24), said two vibrating arms (21a, b) combined into the form of a tuning fork from the side of said vibrating arms, and vibrations are applied to said two vibrating arms combined into the form of a tuning fork when said hitting portion hits against said coupling member.

21. A portable power supply unit according to Claim 16, wherein said vibration applying mechanism includes a vibration applying member (65) having a first portion to widen the distance between said free ends (23) of said two vibrating arms (21a, b) combined into the form of a tuning fork, and a second portion sufficiently thin to pass between said free ends of said two vibrating arms, said two vibrating arms being vibrated by alternately inserting said first and second portions between said free ends of said two vibrating arms.

22. A portable power supply unit comprising said piezoelectric power generator according to any one of Claims 1 to 15 and/or according to any of Claims 16 to 21, including a rectifying device (2) for rectifying the alternating current output from said power generating section, and an electric condensing device (4, 5) for accumulating a rectified current.

23. A portable electronic device comprising said piezoelectric power generator according to any one of Claims 1 to 15 and/or a portable power supply unit according to any one of Claims 16 to 22.
